# EUROPÄISCHE PATENTSCHRIFT

(11) **EP 3 662 232 B1**
(45) Veröffentlichungstag und Bekanntmachung des Hinweises auf die Patenterteilung: **05.04.2023**
(21) Anmeldenummer: 18749752.4
(22) Anmeldetag: 27.07.2018
(51) Int. Cl.: G01D 4/02, G01D 7/00

(54) **MESSSIGNALGERAET FUER EINE PHYSIKALISCHE GROESSE**
MEASUREMENT SIGNAL DEVICE FOR A PHYSICAL VARIABLE
APPAREIL A SIGNAL DE MESURE POUR UNE GRANDEUR PHYSIQUE

(30) Priorität: 01.08.2017 BE 201705538
(43) Veröffentlichungstag der Anmeldung: 10.06.2020
(73) Patentinhaber: Phoenix Contact GmbH & Co. KG, 32825 Blomberg (DE)
(72) Erfinder: JANKOWSKI, Martin, 30926 Seelze (DE)
(74) Vertreter: Patentship Patentanwaltsgesellschaft mbH
(86) Internationale Anmeldenummer: PCT/EP2018/070392
(87) Internationale Veröffentlichungsnummer: WO 2019/025302

(56) Entgegenhaltungen:
- EP-A1- 1 757 222
- DE-A1-102009 055 093
- DE-A1-102013 204 535
- DE-A1-102014 112 033
- DE-U1-202015 101 634

## Beschreibung

Die vorliegende Offenbarung betrifft ein Messsignalgerät für eine physikalische Größe, insbesondere elektrische Energie.

Ein Messsignalgerät kann üblicherweise mindestens einen Messwert über eine optische Anzeige darstellen und den Messwert in einem Intervall aktualisieren. Der mindestens eine Messwert kann über eine Kommunikationsschnittstelle des Messsignalgeräts von einer Verarbeitungseinheit erfassbar sein. Nachteilig an dieser Art der Messwerterfassung ist der erhöhte Bauteilaufwand, welcher für die Verarbeitungseinheit und/oder die Kommunikationsschnittstelle notwendig sein kann. Das Erfassen des Messwertes kann auch visuell, mittels Ablesen durch einen Benutzer des Messsignalgeräts realisiert sein, wobei das Ablesen des Messwertes den Nachteil einer erhöhten Fehleranfälligkeit aufweist. Die DE 20 2015 101634 U1 offenbart ein Verbrauchserfassungsgerät.

Die EP 1 757 222 A1 offenbart eine Messvorrichtung.

Die DE 10 2009 055093 A1 offenbart ein Feldgerät zum Messen einer physikalischen Messgröße.

Die DE 10 2014 112 033 A1 offenbart eine elektrische Messvorrichtung mit einer Codierungseinheit, welche zum Codieren von Messdaten in der Form eines Strichcodes ausgelegt ist, und eine Anzeigeeinheit aufweist, welche zum Anzeigen des Strichcodes ausgelegt ist.

Die DE 10 2013 204535 A1 offenbart einen Busteilnehmer für einen Feldbus der Automatisierungstechnik, mit einem Bedienelement und einem grafiktauglichen Display, welches zur Anzeige eines zweidimensionalen Codes geeignet ist.

Es ist die Aufgabe der vorliegenden Offenbarung, ein verbessertes Messsignalgerät zu schaffen.

Diese Aufgabe wird durch die Merkmale der unabhängigen Ansprüche gelöst. Vorteilhafte Ausführungsformen sind Gegenstand der abhängigen Ansprüche, der Beschreibung sowie der beiliegenden Figuren.

Die vorliegende Offenbarung basiert auf der Erkenntnis, dass die obige Aufgabe durch ein Messsignalgerät gelöst werden kann, welches einen Messwert als Teil eines digitalen Codes über eine Anzeige bereitstellt. Der Code weist zusätzlich eine Handhabungsanweisung bezüglich des Messwertes auf, welche von einem Lesegerät genutzt werden kann, um den Messwert zu verarbeiten. Der Code kann als graphischer Code, insbesondere als zweidimensionaler Code, QR-Code und/oder binärer Code von der Anzeige optisch dargestellt werden.

Dadurch kann der Messwert beispielsweise von der Anzeige des Messsignalgeräts effizient und fehlerfrei insbesondere mit Hilfe einer in das Lesegerät integrierten Kamera erfasst werden.

Gemäß einem ersten Aspekt betrifft die Offenbarung ein Messsignalgerät für eine physikalische Größe gemäß Anspruch 1.

In einer Ausführungsform umfasst das Messsignalgerät einen Sensor zur Erfassung der physikalischen Größe, wobei der Sensor mit dem Sensoranschluss zum Bereitstellen der physikalischen Größe elektrisch verbunden oder Teil des Sensoranschlusses ist. Auf diese Weisen können weitere Sensoren besonders einfach angebunden werden.

In einer Ausführungsform umfasst das Messsignalgerät eine Kommunikationsschnittstelle zum Empfangen der physikalischen Größe, wobei die Kommunikationsschnittstelle mit dem Sensoranschluss zum Bereitstellen der physikalischen Größe elektrisch verbunden ist. Die Kommunikationsschnittstelle kann drahtgebunden oder drahtlos sein.

Das Messsignalgerät kann die physikalische Größe in einen diskreten Messwert wandeln, welcher dem Prozessor in digitaler Form bereitgestellt sein kann.

Das Messsignalgerät ist für die periodische Erfassung der physikalischen Größe ausgebildet, wobei die Anzeige ausgebildet ist, die Darstellung des graphisch darstellbaren Codes bei jeder Erfassung der physikalischen Messgröße zu aktualisieren. Insbesondere kann mit jeder Erfassung der physikalischen Größe ein neuer graphisch darstellbarer Code erzeugt werden, welcher den aktuellsten Messwert enthalten kann. Weiterhin kann der graphisch darstellbare Code eine Mehrzahl von Messwerten aufweisen, wobei die Mehrzahl von Messwerten über einen bestimmten Zeitraum von dem Sensor erfasst worden sein können.

In einer Ausführungsform umfasst die Handhabungsanweisung eine Anweisung zum Aussenden des Messwertes an eine Netzwerkadresse und/oder eine Netzwerkadresse.

Die Netzwerkadresse kann ein Verweis auf eine Internetseite, eine Emailadresse und/oder eine Mobilfunknummer sein. Die Handhabungsanweisung kann eine Weitergabe des Messwerts an eine Internetseite durch ein Lesegerät veranlassen, wobei der Messwert in den Inhalt der Internetseite integriert sein kann und der Inhalt der Internetseite durch eine Anzeige des Lesegeräts darstellbar sein kann. Die Handhabungsanweisung kann das Aussenden einer Nachricht, welche zumindest den Messwert umfasst, durch das Lesegerät auslösen. Die Nachricht kann insbesondere eine Textnachricht sein, welche an eine Mobilfunknummer und/oder eine Emailadresse gesendet werden kann.

Die Handhabungsanweisung kann einen Verweis auf Inhalte, welche in einem Netzwerk und/oder auf dem Lesegerät gespeichert sind verweisen. Insbesondere können diese Inhalte Informationen bezüglich der Funktionsweise, des Funktionsumfanges, der Konfigurationsmöglichkeiten des Messsignalgeräts und/oder der aktuellen Konfiguration des Messsignalgeräts bereitstellen.

Das Aussenden des Messwertes an eine Netzwerkadresse durch das Lesegerät erreicht den Vorteil, dass eine Infrastruktur zum insbesondere zentralen Erfassen des Messwertes lediglich für den Zeitraum des Erfassens des graphisch darstellbaren Codes durch das Lesegerät bereitgestellt sein kann. Die Infrastruktur kann insbesondere durch das Lesegerät bereitgestellt sein, welches eine Netzwerkverbindung aufweisen kann. Somit können der Geräteaufwand und/oder die Kosten für eine zentrale, insbesondere netzwerkabhängige Erfassung der physikalischen Größe vorteilhaft reduziert sein.

In einer Ausführungsform weist die Handhabungsanweisung ferner eine Geräteinformation über das Messsignalgerät, insbesondere eine Angabe über die Art und/oder über die physikalische Einheit der physikalischen Größe, auf.

Die Geräteinformation kann die Spezifikation des Sensors und/oder Informationen bezüglich des Erfassens der physikalischen Messgröße bereitstellen. Diese können beispielsweise einen Toleranzbereich des Messwertes, eine Genauigkeitsangabe des Messwertes, einen minimal und/oder einen maximal durch den Sensor erfassbarer Wert der physikalischen Größe, eine zeitliche Auflösung des Messwertes, eine Zeitdauer der Erfassung der physikalischen Größe und/oder eine Formatspezifikation des Messwertes umfassen. Dadurch wir der Vorteil erreicht, dass der Messwert eine präzise Angabe der physikalischen Größe darstellt und Fehler in der Verarbeitung des Messwertes, insbesondere durch das Lesegerät und/oder bei der Interpretation des Messwertes durch einen Benutzer vermieden werden können. Insbesondere Ablesefehler und/oder Umrechnungsfehler der Einheit des Messwertes können vermieden werden.

In einer Ausführungsform umfasst das Messsignalgerät ferner eine Benutzerschnittstelle zur Konfiguration der Handhabungsanweisung.

Über die Benutzerschnittstelle kann ein Benutzer mit dem Messsignalgerät interagieren. Der Prozessor kann ausgebildet sein Steuerbefehle und/oder Eingaben des Benutzers, welche beispielsweise über Tasten eingegeben werden können, zu verarbeiten, um eine Aktion auszuführen und insbesondere eine Rückmeldung bezüglich der Steuerbefehle und/oder der Eingaben des Benutzers mittels der Anzeige darzustellen.

Die Benutzerschnittstelle kann weiterhin eine akustische und/oder optische Schnittstelle des Messsignalgerätes sein, sodass akustische und/oder optische Signale von dem Messsignalgerät erfasst und verarbeitet werden können.

Durch die Konfigurierbarkeit der Handhabungsanweisung können die über den graphisch darstellbaren Code bereitgestellten Informationen an Anforderungen eines Benutzers angepasst werden, sodass das Messsignalgerät universell einsetzbar sein kann und der Anwendungsbereich des Messsignalgeräts vorteilhaft vergrößert sein kann.

In einer Ausführungsform ist der Inhalt, insbesondere eine oder mehrere ausführbare Funktionen, der Handhabungsanweisung über die Benutzerschnittstelle eingebbar oder konfigurierbar.

Dadurch wird der Vorteil erreicht, dass die Verarbeitung, insbesondere eine Auswertung und/oder eine Darstellung des Messwerts konfiguriert werden kann und über die Benutzerschnittstelle auch während des Betriebs des Messsignalgeräts änderbar sein kann.

In einer Ausführungsform ist die Benutzerschnittstelle eine berührungssensitive Schnittstelle oder eine Eingabeschnittstelle oder eine drahtlose Schnittstelle, insbesondere eine RFID-Schnittstelle oder eine NFC-Schnittstelle.

Durch die Ausbildung der Benutzerschnittstelle als eine elektronische Schnittstelle wird der Vorteil erreicht, dass die Konfiguration des Messsignalgerätes beispielsweise nicht vor Ort direkt am Messsignalgerät sondern auch aus der Ferne, beispielsweise von einer externen Datenverarbeitungsvorrichtung aus erfolgen kann. Weiterhin kann über die elektronische Schnittstelle eine insbesondere vordefinierte Konfiguration auf das Messsignalgerät übertragen werden. Dadurch kann insbesondere eine Mehrzahl von Messsignalgeräten mit einer identischen Konfiguration betrieben werden, wobei durch die elektronische Übertragung der Konfiguration das Auftreten eines durch die Übertragung der Konfiguration hervorgerufenen Fehlers vorteilhaft reduziert sein kann.

In einer Ausführungsform umfasst die Benutzerschnittstelle ein haptisches Bedienelement, welches ausgebildet ist, eine haptische Benutzereingabe in elektronische Steuersignale zum Konfigurieren der Handhabungsanweisung, des Formats des Messwerts und/oder des graphisch darstellbaren Codes zu wandeln und dem Prozessor bereitzustellen.

Dadurch wird der Vorteil erreicht, dass die Konfiguration des Messsignalgerätes direkt über das haptische Bedienelement am Messsignalgerät durch einen Benutzer und/oder ohne weiteren Geräteaufwand durchgeführt werden kann.

In einer Ausführungsform ist über die Benutzerschnittstelle eine Eigenschaft des graphisch darstellbaren Codes konfigurierbar, und der Prozessor ist ausgebildet, den graphischdarstellbaren Code gemäß der eingegeben Eigenschaft zu erzeugen.

Dadurch wird der Vorteil erreicht, dass die Art des angezeigten graphisch darstellbaren Codes, insbesondere an Vorgaben des Lesegerätes angepasst werden kann. Beispielsweise kann das Lesegerät auf das Auslesen eines bestimmten graphisch darstellbaren Codes beschränkt sein, sodass durch die Anpassung des graphisch darstellbaren Codes das Auslesen des graphisch darstellbaren Codes ein solches Lesegerät genutzt werden kann. Weiterhin kann das Format und/oder die Darstellung des Codes konfiguriert werden.

Zusätzlich wird dadurch der Vorteil erreicht, dass die Anzeige des graphisch darstellbaren Codes an Vorgaben des Lesegerätes angepasst werden kann. Diese Anpassung kann beispielsweise die Größe, Position, Farbe und/oder Helligkeit des graphisch darstellbaren Codes und/oder der Anzeige selbst umfassen.

In einer Ausführungsform ist der graphisch darstellbare Code ein eindimensionaler oder ein zweidimensionaler und/oder ein Matrix-Code, insbesondere ein QR-Code und/oder ein binärer Code.

Dadurch wird der Vorteil erreicht, dass der graphisch darstellbare Code effizient und mit einer geringen Lesefehlerrate von einer Kamera erfasst werden kann. Die Lesefehlerrate kann insbesondere durch die Art der Codierung skalierbar sein. Weiterhin kann der graphisch darstellbare Code Prüfsummen und/oder redundante respektive zusätzliche Daten aufweisen, sodass ein fehlerhaftes Erfassen des graphisch darstellbaren Codes durch das Lesegerät festgestellt und/oder korrigiert werden kann.

Das Messsignalgerät kann insbesondere ausgebildet sein eine Mehrzahl von verschiedenen Matrix-Codes, beispielsweise QR-Codes, Datamatrix-Codes, Maxi-Codes und/oder Aztec-Codes zu generieren und darzustellen. Weiterhin können eindimensionale binäre Codes, insbesondere Barcodes von dem Prozessor generiert und von der Anzeige dargestellt werden. Ein Wechsel des verwendeten graphisch darstellbaren Codes kann bei einem Wechsel des Lesegeräts notwendig sein. Ein Austausch des Messsignalgeräts muss nicht zusätzlich erfolgen, sondern lediglich die Konfiguration des graphisch darstellbaren Codes kann angepasst werden. Weiterhin kann dem Messsignalgerät über die Benutzerschnittstelle ein neues Codeformat bereitgestellt sein, sodass auch zukünftige, graphisch darstellbare Codes von dem Messsignalgerät generiert und dargestellt werden können.

In einer Ausführungsform ist die physikalische Größe elektrische Energie oder elektrische Leistung.

Das Messsignalgerät ist ausgebildet eine Mehrzahl von physikalischen Größen aufzunehmen und die aufgenommene Mehrzahl der physikalischen Größen zu verarbeiten, beispielsweise aufzusummieren, um den Messwert zu erhalten.

Erfindungsgemäß wird die aufgenommene Mehrzahl der physikalischen Größen multipliziert, summiert und/oder mittels einer Fourier-Transformation verarbeitet. Dies kann insbesondere zum Erfassen eines elektrischen Stroms, einer elektrischen Spannung, einer elektrischen Leistung und/oder einer elektrischen Energie genutzt werden.

Dadurch wird der Vorteil erreicht, dass das Messsignalgerät als Energiezähler zum Messen einer von einem Verbraucher verbrauchten elektrischen Energiemenge eingesetzt werden kann. Insbesondere kann das Messsignalgerät einen aktuellen Fluid- und/oder Energieverbrauchswert und einen akkumulierten Fluid- und/oder Energieverbrauchswert bereitstellen.

In einer Ausführungsform ist der Sensor ausgebildet, eine Mehrzahl von physikalischen Größen zu erfassen, um eine Mehrzahl von Messwerten zu erhalten. Dadurch wird der Vorteil erreicht, dass ein Messsignalgerät zur Erfassung einer Mehrzahl von physikalischen Größen genutzt werden kann und/oder für die Erfassung unterschiedlicher physikalischer Größen an unterschiedlichen Orten das gleiche Messsignalgerät verwendet werden kann. Die Mehrzahl von physikalischen Größen kann insbesondere elektromagnetische Größen und/oder Größen der Umgebung des Messsignalgerätes umfassen. Insbesondere kann die Mehrzahl von physikalischen Größen eine Anzahl der folgenden physikalischen Größen umfassen: Wärmemenge, elektrische Stromstärke, elektrische Leistung, elektrische Spannung, Flussgeschwindigkeit eines Fluides, Temperatur, Druck, Helligkeit, Luftfeuchtigkeit, Niederschlagsmenge, Energieverbrauch, akkumulierte Durchflussmenge eines Fluides, elektrische Energie.

In einer Ausführungsform sind über die Benutzerschnittstelle eine Anzahl von Messwerten der Mehrzahl von Messwerten und/oder eine Mehrzahl von Handhabungsanweisungen zum elektronischen Handhaben der Anzahl von Messwerten für die Codierung in den graphisch darstellbaren Code auswählbar. Dadurch wird der Vorteil erreicht, dass nicht nur ein einzelner Messwert, sondern eine Mehrzahl von Messwerten von dem Lesegerät über den dargestellten graphisch darstellbaren Code erfasst und verarbeitet werden kann. Das Messsignalgerät kann weiterhin ausgebildet sein eine Mehrzahl von Messwerten einer physikalischen Größe bereitzustellen, wobei die jeweiligen Messwerte der Mehrzahl von Messwerten an unterschiedlichen Orten erfasst sein können. So kann beispielsweise bei der elektrischen Leistungsmessung einer Mehrzahl von Verbrauchern ein Messsignalgerät eine Mehrzahl von Messsignalgeräten ersetzen.

In einer Ausführungsform sind die Handhabungsanweisung und/oder der Messwert durch eine alphanumerische Zeichenkette gebildet, wobei die alphanumerische Zeichenkette durch die Anzeige graphisch darstellbar ist.

Der graphisch darstellbare Code stellt eine effiziente Form einer maschinenlesbaren graphischen Information dar, sodass der graphisch darstellbare Code vorteilhaft für das Auslesen durch das insbesondere elektronische Lesegerät verwendet werden kann. Die in dem graphisch darstellbaren Code enthaltene Information kann von einem Benutzer, welcher die Anzeige betrachtet möglicherweise nicht direkt und/oder nicht unter Zuhilfenahme zusätzlicher Geräte und/oder Hilfsmittel decodiert werden. Es ist daher vorteilhaft den Messwert und/oder die Handhabungsanweisung zusätzlich und/oder im Wechsel zu der Darstellung des graphisch darstellbaren Codes auch als alphanumerische Zeichenkette mittels der Anzeige darzustellen. Dadurch wird der Vorteil erreicht, dass der Messwert direkt an dem Messsignalgerät von dem Benutzer abgelesen werden kann.

Die alphanumerische Zeichenkette kann dabei insbesondere den Messwert und die physikalische Einheit des Messwertes umfassen. Die alphanumerische Zeichenkette kann periodisch, insbesondere mit einer neuen Erfassung der physikalischen Messgröße aktualisiert werden. Das Aktualisierungsintervall kann dabei auf einen Minimalwert beschränkt sein, um ein Ablesen durch den Benutzer zu erleichtern.

In einer Ausführungsform ist der Prozessor ausgebildet den Messwert und/oder die Handhabungsanweisung zu verschlüsseln und den verschlüsselten Messwert und/oder die verschlüsselte Handhabungsanweisung in den graphisch darstellbaren Code zu codieren.

Dadurch wird der Vorteil erreicht, dass insbesondere sicherheitsrelevante Messwerte und/oder sicherheitsrelevante Handhabungsanweisungen vor unbefugtem Zugriff geschützt sein können. Das Format des verwendeten graphisch darstellbaren Codes kann einem offenliegenden Standard oder einer allgemein bekannten Spezifikation entsprechen, sodass allein durch die Codierung des Messwertes und/oder der Handhabungsanweisung nur ein reduzierter Schutz vor unbefugtem Zugriff auf den Messwert und/oder die Handhabungsanweisung realisiert sein kann. Durch die Verschlüsselung kann das Messsignalgerät an ein spezifisches Lesegerät gekoppelt sein, welches ausgebildet ist, den verschlüsselten Messwert und/oder die verschlüsselte Handhabungsanweisung zu entschlüsseln.

Weiterhin wird durch eine Verschlüsselung der Vorteil erreicht, dass die in dem graphisch darstellbaren Code enthaltenen Daten dem Lesegerät nicht zugänglich sein können. Das Lesegerät kann den graphisch darstellbaren Code auslesen und die darin enthaltenen Daten insbesondere entsprechend der Handhabungsanweisung in einem internen Speicher ablegen und/oder an die externe Datenverarbeitungsvorrichtung weiterleiten. Daher kann es vorteilhaft sein den Messwert zu verschlüsseln und die Handhabungsanweisung unverschlüsselt mittels des graphisch darstellbaren Codes zu übertragen.

In einer Ausführungsform ist der Prozessor ausgebildet, den graphisch darstellbaren Code elektrisch, insbesondere drahtlos zu einem Lesegerät übertragbar bereitzustellen.

Die drahtlose Übertragung kann insbesondere eine Funkübertragung sein, welche auf einem Nahbereichs- oder Fernfunkstandard basiert. Insbesondere kann die Funkübertragung durch eine WLAN-, Bluetooth-, NFC-, UMTS,- LTE-, und/oder 5G-Verbindung realisiert sein. Dadurch wird der Vorteil erreicht, dass größere Distanzen als bei einer optischen Erfassung des graphisch darstellbaren Codes möglich sein können, zwischen dem Lesegerät und dem Messsignalgerät liegen können. Weiterhin kann eine Erfassung mittels einer Funkübertragung ein Ablesen des Messwertes ermöglichen, falls die Anzeige des Messsignalgeräts für die optische Erfassungseinrichtung des Lesegeräts optisch unzugänglich angeordnet ist.

Gemäß einem zweiten Aspekt betrifft die Offenbarung ein System gemäß Anspruch 14, mit einem Messsignalgerät gemäß Anspruch 1 und einem Lesegerät.

Das Lesegerät kann insbesondere ein tragbares Benutzerendgerät, insbesondere ein Smartphone oder Tablet sein. Der Prozessor des Lesegerätes kann ferner ausgebildet sein ein Softwareprogramm auszuführen welche das Auslesen des graphisch darstellbaren Codes von dem Messsignalgerät, das Decodieren des graphisch darstellbaren Codes, ein Darstellen der in dem graphisch darstellbaren Code enthaltenen Daten und/oder ein Ausführen der Handhabungsanweisung realisiert. Das Lesegerät kann einen Speicher aufweisen, um den Messwert und/oder die Handhabungsanweisung zu speichern. In einer Ausführungsform weist die Handhabungsanweisung eine Anweisung zum Aussenden des Messwertes über ein Kommunikationsnetzwerk an eine Netzwerkadresse auf, wobei das Lesegerät eine Kommunikationsschnittstelle aufweist, welche ausgebildet ist, den Messwert an die Netzwerkadresse über das Kommunikationsnetzwerk, insbesondere drahtlos oder drahtgebunden, auszusenden.

Das Lesegerät kann eine Netzwerkschnittstelle zur Verbindung mit einem drahtgebundenen und/oder drahtlosen Kommunikationsnetzwerk, insbesondere einem Mobilfunknetzwerk aufweisen, um den graphisch darstellbaren Code, den Messwert und/oder die Handhabungsanweisung an die externe Datenverarbeitungsvorrichtung weiterzuleiten.

Das Messsignalgerät kann in periodischen Zeitabständen mit der Erfassung der physikalischen Größe einen diskreten Messwert generieren, wobei ein zuvor generierter Messwert nicht mehr zur Integration in den graphisch darstellbaren Code zur Verfügung stehen kann. Innerhalb einer Erfassungsperiode kann der Prozessor den diskreten Messwert mit der Handhabungsanweisung in den graphisch darstellbaren Code wandeln.

Weiterhin kann das Messsignalgerät einen Speicher aufweisen, in welchem die insbesondere periodisch erfassten Messwerte der physikalischen Messgröße speicherbar sind.

Weitere Ausführungsbeispiele werden Bezug nehmend auf die beiliegenden Figuren erläutert. Es zeigen:
Fig. 1 ein Messsignalgerät in einer Ausführungsform;
Fig. 2 ein Messsignalgerät und eine Auslesevorrichtung in einer Ausführungsform; und
Fig. 3 ein Messsignalgerät und eine Auslesevorrichtung in einer Ausführungsform.

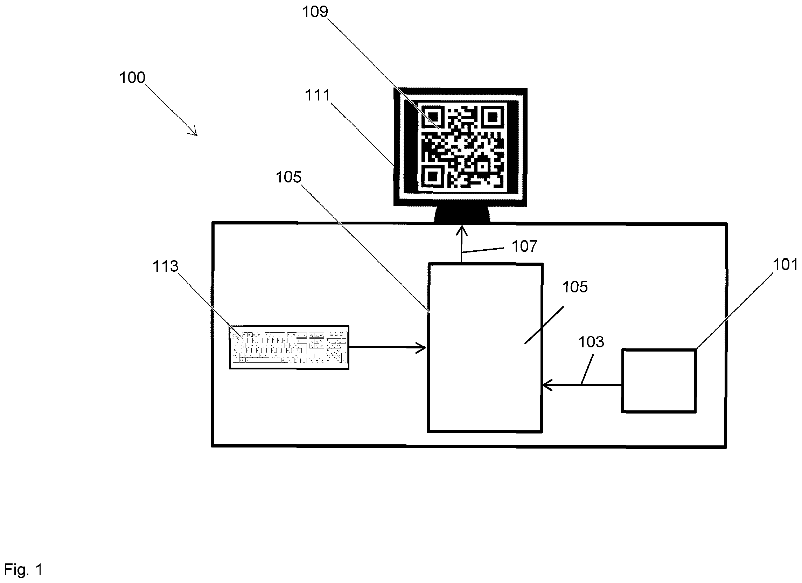

Fig. 1 zeigt eine schematische Darstellung des Messsignalgerätes 100 für eine physikalische Größe, mit einem Sensoranschluss 101 zur Erfassung der physikalischen Größe, um einen Messwert 103 zu erhalten, einem Prozessor 105, welcher ausgebildet ist, dem Messwert 103 eine Handhabungsanweisung 107 zum elektronischen Handhaben des Messwertes 103 zuzuordnen, wobei der Prozessor 105 ferner ausgebildet ist, den Messwert 103 zusammen mit der Handhabungsanweisung 107 in einen graphisch darstellbaren Code 109 zu codieren, und einer Anzeige 111, welche ausgebildet ist, den graphisch darstellbaren Code 109 graphisch darzustellen.

Ferner umfasst das Messsignalgerät 100 eine Benutzerschnittstelle 113 zur Konfiguration der Handhabungsanweisung 107. Die Benutzerschnittstelle 113 ist insbesondere ein haptisches Bedienelement, beispielsweise eine Tastatur, ein Tastenfeld oder eine berührungsempfindliche Fläche. Die Benutzerschnittstelle 113 kann mit der Anzeige 111 verbunden sein, um über die Benutzerschnittstelle 113 eingegebene Benutzereingaben auf der Anzeige 111 darzustellen.

Die Benutzerschnittstelle 113 ist ausgebildet eine Benutzereingabe in elektronische Steuersignale zum Konfigurieren der Handhabungsanweisung 107, des Formats des Messwerts 103 und/oder des graphisch darstellbaren Codes 109 zu wandeln. Weiterhin ist über die Benutzerschnittstelle 113 eine Eigenschaft des graphisch darstellbaren Codes 109 konfigurierbar ist, wobei der Prozessor 105 ausgebildet ist, den graphischdarstellbaren Code 109 gemäß der eingegeben Eigenschaft zu erzeugen.

Zusätzlich oder anstelle des haptischen Bedienelements kann eine elektronische oder optische Benutzerschnittstelle vorgesehen sein. Über die elektronische oder optische Benutzerschnittstelle kann eine leitungsgebundene oder eine drahtlose Verbindung zwischen einem Benutzerendgerät und dem Messsignalgerät 100 realisiert werden und über diese Verbindung die Benutzereingabe an den Prozessor 105 übermittelt werden. Die elektronische Benutzerschnittstelle 113 kann eine drahtlose Schnittstelle, insbesondere eine RFID-Schnittstelle oder eine NFC-Schnittstelle sein.

Der Inhalt, insbesondere eine oder mehrere ausführbare Funktionen, der Handhabungsanweisung 107 über die Benutzerschnittstelle 113 eingebbar oder konfigurierbar ist.

Mit der Benutzereingabe sind das Format und/oder die Art des graphisch darstellbaren Codes 109, der Inhalt des graphisch darstellbaren Codes 109 und/oder die Darstellung des graphisch darstellbaren Codes 109 durch die Anzeige 111 konfigurierbar. So können gerätespezifische und/oder anwenderspezifische Informationen und/oder Funktionen in den graphisch darstellbaren Code 109 integriert werden.

Der graphisch darstellbare Code 109 ist ein zweidimensionaler Code, welcher sich aus Flächen unterschiedlicher Helligkeit und/oder unterschiedlicher Farbe zusammensetzt. Die Flächen sind in einem regelmäßigen Gitter angeordnet. Der graphisch darstellbare Code 109 ist ein Matrix-Code, wobei der Matrix-Code ein QR-Code sein kann.

Zusätzlich zu dem Matrix-Code kann auf der Anzeige 111 eine alphanumerische Zeichenkette 201 dargestellt, welche den Messwert 103 und beispielsweise eine Abkürzung und/oder ein Symbol für die physikalische Einheit des Messwertes 103 enthält.

Die Anzeige 111 ist ein Bildschirm, wobei die Anzahl der Bildpunkte des Bildschirms mindestens der Anzahl der Elemente des zweidimensionalen Codes 109 entspricht, um den zweidimensionalen Code 109 vollständig darzustellen. Weiterhin ist der Farb- und/oder Kontrastunterschied zwischen den Flächen hoch genug, um von einer externen Kamera erfasst zu werden, sodass eine separate Erfassung der einzelnen Flächen des zweidimensionalen Codes 109 möglich ist.

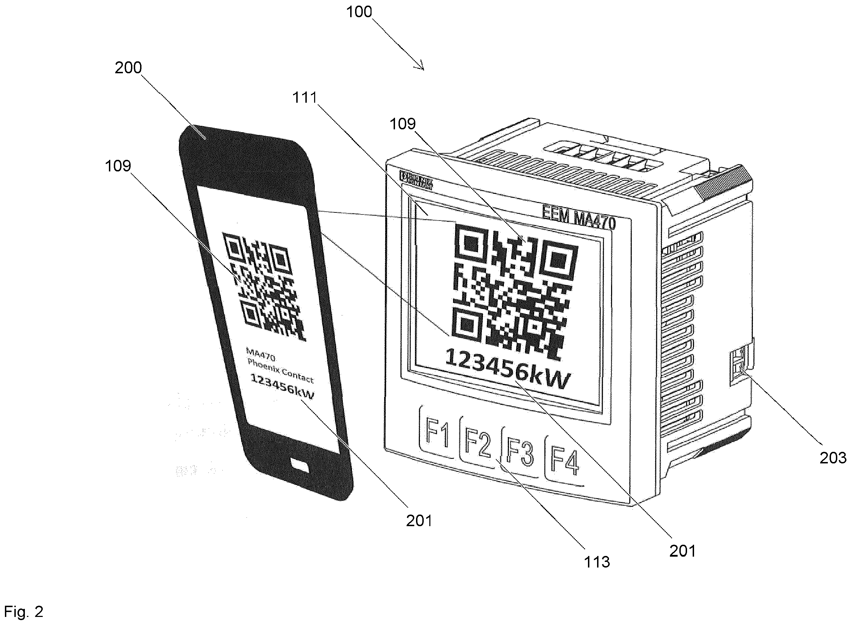

Fig. 2 zeigt eine schematische Darstellung des Messsignalgerätes 100 für eine physikalische Größe, mit einer Anzeige 111, welche ausgebildet ist, den graphisch darstellbaren Code 109 graphisch darzustellen und mit einer Benutzerschnittstelle 113 zur Konfiguration der Handhabungsanweisung. Weiterhin ist ein Lesegerät 200 zum Auslesen eines mittels einer Anzeige 111 graphisch darstellbaren Codes 109 dargestellt. Der graphisch darstellbare Code 109 weist eine Angabe über einen Messwert 103 einer physikalischen Größe sowie eine Handhabungsanweisung 107 zur elektronischen Handhabung des Messwertes 103 auf. Das Lesegerät 200 weist eine optische Erfassungseinrichtung, insbesondere einer Bildkamera, welche ausgebildet ist, den graphisch darstellbaren Code 109 optisch zu erfassen, und einen Prozessor auf, welcher ausgebildet ist, den graphisch darstellbaren Code 109 zu decodieren, um den Messwert 103 sowie die Handhabungsanweisung 107 zu erhalten. Das Lesegerät 200 ist ausgebildet, den Messwert 103 entsprechend der Handhabungsanweisung 107 zu handhaben.

Weiterhin ist ein Verfahren zum Erfassen des graphisch darstellbaren Codes 109 durch das Lesegerät 200 gezeigt, welches den graphisch darstellbaren Code 109 mit einer in das Lesegerät 200 integrierten Bildkamera erfasst und mittels des Prozessors des Lesegeräts 200 den graphisch darstellbaren Code 109 decodiert, um den Messwert 103 und/oder die Handhabungsanweisung 107 zu erhalten. Der Prozessor des Lesegeräts 200 kann ausgebildet sein einen verschlüsselten Messwert und/oder eine verschlüsselte Handhabungsanweisung 107 zu entschlüsseln.

Das Lesegerät 200 weist eine Anzeige auf, welche den graphisch darstellbaren Code 109, den Messwert 103 und/oder die Handhabungsanweisung 107 darstellen kann. Das Lesegerät 200 ist ein Smartphone, welches ein Aussenden einer Nachricht mit dem Messwert 103 entsprechend der Handhabungsanweisung 107 über ein drahtgebundenes und/oder drahtloses Netzwerk, insbesondere ein Mobilfunknetzwerk, ermöglicht.

Der graphisch darstellbare Code 109 ist ein zweidimensionaler, binärer Code, insbesondere ein QR-Code. Der zweidimensionale, binäre Code besteht aus einer quadratischen Matrix aus Symbolelementen. Diese Symbolelemente sind insbesondere Quadrate, welche eine unterschiedliche Farbe und/oder Helligkeit aufweisen und insbesondere schwarz oder weiß sind.

Jeweils eine Positionsmarkierung in drei der vier Ecken des Quadrats beschreibt die Orientierung des graphisch darstellbaren Codes 109. Die in dem graphisch darstellbaren Code 109 enthaltenen Daten, insbesondere der Messwert 103 und die Handhabungsanweisung 107 können durch einen fehlerkorrigierenden Code geschützt sein. Dadurch können bei Verlust eines Teils des graphisch darstellbaren Codes 109, beispielsweise von bis zu 30 % des graphisch darstellbaren Codes 109, die Daten dennoch verlustfrei aus dem graphisch darstellbaren Code 109 decodiert werden. Zwischen den drei Positionsmarkierungen befindet sich eine Linie aus einer Folge abwechselnder Bits, worüber die Matrix definiert ist. Die Symbolelemente können in einer quadratischen Matrix mit einer Breite von beispielsweise mindestens 21 und beispielsweise maximal 177 Symbolelementen angeordnet sein. Es kann eine Randzone definiert sein, welche keine Nutzdaten enthält und beispielsweise mindestens 4 Elemente breit ist. Eine größere Menge an Daten kann auf mehrere, beispielsweise auf bis zu 16 einzelne graphisch darstellbare Codes 109 aufgeteilt werden.

Die alphanumerische Zeichenkette 201 kann gleichzeitig oder im Wechsel mit dem graphisch darstellbaren Code 109 durch die Anzeige 111 dargestellt sein.

Die Benutzerschnittstelle 113 ist durch vier Bedienelemente gebildet, welche die Bezeichnungen F1, F2, F3 und F4 aufweisen und in einer Reihe unterhalb der Anzeige 111 angeordnet sind. Die Bedienelemente können insbesondere mechanische, kapazitive und/oder resistive Taster oder Schalter sein. Die Anzeige 111 und die Bedienelemente sind in einer Seitenfläche eines Gehäuse angeordnet, welches den Sensoranschluss 101 und den Prozessor 105 enthält. Das Gehäuse kann eine elektrische Anschlusseinheit 203 für die Stromversorgung des Messsignalgeräts 100 und/oder die elektrische Zuleitung eines Messsignals zu dem Sensor 101 aufweisen.

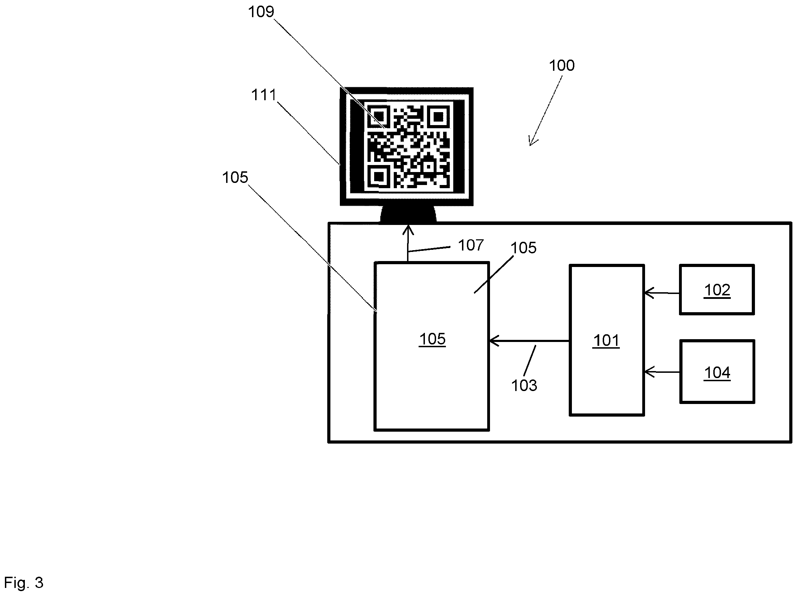

Fig. 3 zeigt das Messsignalgerät 100 in einer Ausführungsform, das ferner einen Sensor 102 zur Erfassung der physikalischen Größe aufweist, wobei der Sensor mit dem Sensoranschluss 101 zum Bereitstellen der physikalischen Größe elektrisch verbunden ist. Optional können mehrere Sensoren 102 für die Erfassung unterschiedlicher physikalischer Größen vorgesehen sein, welche elektrisch mit dem Sensoranschluss 101 verbunden oder verbindbar ist.

In Fig. 3 ist ferner ein Element 104 dargestellt, das eine Kommunikationsschnittstelle sein kann, welche den Sensor ersetzen kann oder zusammen mit dem Sensor 102 vorgesehen ist, um die physikalische Größe oder eine weitere physikalische Größe bereitzustellen. Die Kommunikationsschnittstelle 104 kann drahtgebunden, beispielsweise Ethernet, USB, oder drahtlos, beispielsweise WLAN, sein.

Das Element 104 kann jedoch auch ein weiterer Sensor zur Erfassung einer weiteren physikalischen Größe sein.

### Bezugszeichenliste

- 100: Messsignalgerät
- 101: Sensoranschluss
- 102: Sensor
- 103: Messwert
- 104: Kommunikationsschnittstelle
- 105: Prozessor
- 107: Handhabungsanweisung
- 109: Graphisch darstellbarer Code
- 111: Anzeige
- 113: Benutzerschnittstelle
- 200: Lesegerät
- 201: Alphanumerische Zeichenkette
- 203: Anschlusseinheit

## Patentansprüche

1. Messsignalgerät (100) für eine physikalischen Größe, mit:
einem Sensoranschluss (101) zur Bereitstellung der physikalischen Größe, um einen Messwert (103) zu erhalten;
einem Prozessor (105), welcher ausgebildet ist, dem Messwert (103) eine Handhabungsanweisung (107) zum elektronischen Handhaben des Messwertes (103) zuzuordnen, wobei der Prozessor (105) ferner ausgebildet ist, den Messwert (103) zusammen mit der Handhabungsanweisung (107) in einen graphisch darstellbaren Code (109) zu codieren; und
einer Anzeige (111), welche ausgebildet ist, den graphisch darstellbaren Code (109) graphisch darzustellen,
wobei das Messsignalgerät (100) ausgebildet ist, die physikalische Größe periodisch zu erfassen und die Anzeige (111) ausgebildet ist, bei jeder Erfassung der physikalischen Größe die Darstellung des graphisch dargestellten Codes zu aktualisieren,
wobei das Messsignalgerät (100) ausgebildet ist, eine Mehrzahl von physikalischen Größen aufzunehmen und die aufgenommene Mehrzahl der physikalischen Größen zu verarbeiten, um den Messwert (103) zu erhalten, wobei die aufgenommene Mehrzahl der physikalischen Größen multipliziert, summiert und/oder mittels einer Fourier-Transformation verarbeitet wird.

2. Messsignalgerät (100) nach Anspruch 1, wobei die Handhabungsanweisung (107) eine Anweisung zum Aussenden des Messwertes (103) an eine Netzwerkadresse und/oder eine Netzwerkadresse umfasst.

3. Messsignalgerät (100) nach einem der vorstehenden Ansprüche, wobei die Handhabungsanweisung (107) ferner eine Geräteinformation über das Messsignalgerät (100), insbesondere eine Angabe über die Art und/oder über die physikalische Einheit der physikalischen Größe, aufweist.

4. Messsignalgerät (100) nach einem der vorstehenden Ansprüche, welches ferner eine Benutzerschnittstelle (113) zur Konfiguration der Handhabungsanweisung (107) umfasst.

5. Messsignalgerät (100) nach Anspruch 4, wobei der Inhalt, insbesondere eine oder mehrere ausführbare Funktionen, der Handhabungsanweisung (107) über die Benutzerschnittstelle (113) eingebbar oder konfigurierbar ist.

6. Messsignalgerät (100) nach Anspruch 4 oder 5, wobei die Benutzerschnittstelle (113) eine berührungssensitive Schnittstelle oder eine Eingabeschnittstelle oder eine drahtlose Schnittstelle, insbesondere eine RFID-Schnittstelle oder eine NFC-Schnittstelle ist.

7. Messsignalgerät (100) nach einem der Ansprüche 4 bis 6, wobei über die Benutzerschnittstelle (113) eine Eigenschaft des graphisch darstellbaren Codes (109) konfigurierbar ist, und wobei der Prozessor (105) ausgebildet ist, den graphischdarstellbaren Code (109) gemäß der eingegeben Eigenschaft zu erzeugen.

8. Messsignalgerät (100) nach einem der vorstehenden Ansprüche, wobei der graphisch darstellbare Code (109) ein eindimensionaler oder ein zweidimensionaler und/oder ein Matrix-Code, insbesondere ein QR-Code und/oder ein binärer Code ist.

9. Messsignalgerät (100) nach einem der vorstehenden Ansprüche, wobei die physikalische Größe elektrische Energie oder elektrische Leistung ist.

10. Messsignalgerät (100) nach einem der vorstehenden Ansprüche, wobei die Handhabungsanweisung (107) und/oder der Messwert (103) durch eine alphanumerische Zeichenkette (201) gebildet sind, wobei die alphanumerische Zeichenkette (201) durch die Anzeige (111) graphisch darstellbar ist.

11. Messsignalgerät (100) nach einem der vorstehenden Ansprüche, wobei der Prozessor (105) ausgebildet ist, den Messwert (103) und/oder die Handhabungsanweisung (107) zu verschlüsseln und den verschlüsselten Messwert (103) und/oder die verschlüsselte Handhabungsanweisung (107) in den graphisch darstellbaren Code (109) zu codieren.

12. Messsignalgerät (100) nach einem der vorstehenden Ansprüche, wobei der Prozessor (105) ausgebildet ist, den graphisch darstellbaren Code (109) elektrisch, insbesondere drahtlos zu einem Lesegerät (200) übertragbar bereitzustellen.

13. Messsignalgerät (100) nach einem der vorstehenden Ansprüche, das ferner einen Sensor zur Erfassung der physikalischen Größe aufweist, wobei der Sensor mit dem Sensoranschluss (101) zum Bereitstellen der physikalischen Größe elektrisch verbunden ist, und/oder wobei das ferner eine Kommunikationsschnittstelle zum Empfangen der physikalischen Größe aufweist, wobei die Kommunikationsschnittstelle mit dem Sensoranschluss zum Bereitstellen der physikalischen Größe elektrisch verbunden ist.

14. System, umfassend:
ein Messsignalgerät (100) nach einem der vorstehenden Ansprüche; und
ein Lesegerät (200) zum Auslesen eines mittels einer Anzeige (111) graphisch darstellbaren Codes (109), welcher eine Angabe über einen Messwert (103) einer physikalischen Größe, sowie eine Handhabungsanweisung (107) zur elektronischen Handhabung des Messwertes (103) aufweist, wobei das Lesegerät (200) folgendes umfasst:
eine optische Erfassungseinrichtung, insbesondere eine Bildkamera, welche ausgebildet ist, den graphisch darstellbaren Code (109) optisch zu erfassen;
einen Prozessor, welcher ausgebildet ist, den graphisch darstellbaren Code (109) zu decodieren, um den Messwert (103) sowie die Handhabungsanweisung (107) zu erhalten;
wobei das Lesegerät (200) ausgebildet ist, den Messwert (103) entsprechend der Handhabungsanweisung (107) zu handhaben, wobei das Messsignalgerät (100) ausgebildet ist, die physikalische Größe periodisch zu erfassen und die Anzeige (111) ausgebildet ist, bei jeder Erfassung der physikalischen Größe die Darstellung des graphisch dargestellten Codes zu aktualisieren.

## Claims

1. Measuring signal device (100) for a physical variable, comprising:
a sensor connection (101) for providing the physical variable in order to obtain a measurement value (103);
a processor (105), which is configured to assign a handling instruction (107) to the measurement value (103) for electronically handling the measurement value (103), wherein the processor (105) is further configured to encode the measurement value (103) together with the handling instruction (107) into a graphically displayable code (109); and
a display (111), which is configured to graphically display the graphically displayable code (109),
wherein the measuring signal device (100) is configured to periodically capture the physical variable and wherein the display (111) is configured to update the displaying of the graphically displayable code with each capturing of the physical variable,
wherein the measuring signal device (100) is configured to record a plurality of physical variables and to process the recorded plurality of physical variables in order to obtain the measurement value (103), wherein the recorded plurality of physical variables is multiplied, is summed and/or is processed using a Fourier Transformation.

2. Measuring signal device (100) according to claim 1, wherein the handling instruction (107) comprises an instruction for sending out the measurement value (103) to a network address and/or a network address.

3. Measuring signal device (100) according to one of the preceding claims, wherein the handling instruction (107) also comprises device information about the measuring signal device (100), in particular an indication about the type and/or about the physical unit of the physical variable.

4. Measuring signal device (100) according to one of the preceding claims, which further comprises a user interface (113) for configuring the handling instruction (107).

5. Measuring signal device (100) according to claim 4, wherein the content, in particular one or more executable functions, of the handling instruction (107) is inputtable or configurable via the user interface (113).

6. Measuring signal device (100) according to claim 4 or 5, wherein the user interface (113) is a touch-sensitive interface or an input interface or a wireless interface, in particular an RFID interface or an NFC interface.

7. Measuring signal device (100) according to one of claims 4 to 6, wherein a property of the graphically displayable code (109) is configurable via the user interface (113), and wherein the processor (105) is configured to process the graphically displayable code (109) according to the inputted property.

8. Measuring signal device (100) according to one of the preceding claims, wherein the graphically displayable code (109) is a one-dimensional or a two-dimensional and/or a matrix code, in particular a QR code and/or a binary code.

9. Measuring signal device (100) according to one of the preceding claims, wherein the physical variable is electrical energy or electrical power.

10. Measuring signal device (100) according to one of the preceding claims, wherein the handling instructions (107) and/or the measurement value (103) are formed by an alphanumeric character string (201), wherein the alphanumeric character string (201) is graphically displayable by the display (111).

11. Measuring signal device (100) according to one of the preceding claims, wherein the processor (105) is configured to encrypt the measurement value (103) and/or the handling instruction (107) and to encode the encrypted measurement value (103) and/or the encrypted handling instruction (107) into the graphically displayable code (109).

12. Measuring signal device (100) according to one of the preceding claims, wherein the processor (105) is configured to provide the graphically displayable code (109) electrically, in particular wirelessly to a reading device (200) in a transmittable manner.

13. Measuring signal device (100) according to one of the preceding claims, which further comprises a sensor for capturing the physical variable, wherein the sensor is electrically connected to the sensor connection (101) for providing the physical variable, and/or wherein the further comprises a communication interface for receiving the physical variable, wherein the communication interface is electrically connected to the sensor connection for providing the physical variable.

14. System, comprising:
a measuring signal device (100) according to one of the preceding claims; and
a reading device (200) for reading out a code (109) which is graphically displayable by means of a display (111), which code comprises information about a measurement value (103) of a physical variable and a handling instruction (107) for electronically handling the measurement value (103), wherein the reading device (200) comprises:
an optical capturing device, in particular an image camera, which is configured to optically capture the graphically displayable code (109);
a processor, which is configured to decode the graphically displayable code (109) in order to obtain the measurement value (103) and the handling instruction (107);
wherein the reading device (200) is configured to handle the measurement value (103) according to the handling instructions (107), wherein the measuring signal device (100) is configured to periodically capture the physical variable and wherein the display (111) is configured to update the displaying of the graphically displayed code with each capturing of the physical variable.

## Revendications

1. Appareil à signal de mesure (100) pour une grandeur physique, comprenant :
un port de capteur (101) destiné à la mise à disposition de la grandeur physique, afin d'obtenir une grandeur mesurée (103) ;
un processeur (105), lequel est configuré pour affecter à la valeur mesurée (103) une instruction de manipulation (107) en vue de la manipulation électronique de la valeur mesurée (103), le processeur (105) étant en outre configuré pour coder la valeur mesurée (103) conjointement avec l'instruction de manipulation (107) en un code (109) pouvant être représenté graphiquement ;
et
un dispositif d'affichage (111), qui est configuré pour représenter sous forme graphique le code (109) pouvant être représenté graphiquement,
l'appareil à signal de mesure (100) étant configuré pour acquérir périodiquement la grandeur physique et le dispositif d'affichage (111) étant configuré pour actualiser la représentation du code représenté graphiquement à chaque acquisition de la grandeur physique,
l'appareil à signal de mesure (100) étant configuré pour enregistrer une pluralité de grandeurs physiques et traiter la pluralité enregistrée des grandeurs physiques afin d'obtenir la valeur mesurée (103), la pluralité enregistrée des grandeurs physiques étant multipliée, additionnée et/ou traitée au moyen d'une transformée de Fourier.

2. Appareil à signal de mesure (100) selon la revendication 1, l'instruction de manipulation (107) comprenant une instruction pour émettre la valeur mesurée (103) vers une adresse de réseau et/ou une adresse de réseau.

3. Appareil à signal de mesure (100) selon l'une des revendications précédentes, l'instruction de manipulation (107) comprenant en outre une information d'appareil à propos de l'appareil à signal de mesure (100), notamment une indication à propos de la nature et/ou à propos de l'unité physique de la grandeur physique.

4. Appareil à signal de mesure (100) selon l'une des revendications précédentes, lequel comporte en plus une interface utilisateur (113) servant à la configuration de l'instruction de manipulation (107).

5. Appareil à signal de mesure (100) selon la revendication 4, le contenu, notamment une ou plusieurs fonctions exécutables de l'instruction de manipulation (107) pouvant être saisies ou configurées par le biais de l'interface utilisateur (113).

6. Appareil à signal de mesure (100) selon la revendication 4 ou 5, l'interface utilisateur (113) étant une interface tactile ou une interface de saisie ou une interface sans fil, notamment une interface RFID ou une interface NFC.

7. Appareil à signal de mesure (100) selon l'une des revendications 4 à 6, une propriété du code (109) pouvant être représenté graphiquement pouvant être configurée par le biais de l'interface utilisateur (113), et le processeur (105) étant configuré pour générer le code (109) pouvant être représenté graphiquement conformément à la propriété saisie.

8. Appareil à signal de mesure (100) selon l'une des revendications précédentes, le code (109) pouvant être représenté graphiquement étant un code unidimensionnel ou bidimensionnel et/ou un code matriciel, notamment un code QR et/ou un code binaire.

9. Appareil à signal de mesure (100) selon l'une des revendications précédentes, la grandeur physique étant de l'énergie électrique ou de la puissance électrique.

10. Appareil à signal de mesure (100) selon l'une des revendications précédentes, l'instruction de manipulation (107) et/ou la valeur mesurée (103) étant formées par une chaîne de caractères alphanumériques (201), la chaîne de caractères alphanumériques (201) pouvant être représentée graphiquement par le dispositif d'affichage (111).

11. Appareil à signal de mesure (100) selon l'une des revendications précédentes, le processeur (105) étant configuré pour crypter la valeur mesurée (103) et/ou l'instruction de manipulation (107) et coder la valeur mesurée (103) cryptée et/ou l'instruction de manipulation (107) cryptée en le code (109) pouvant être représenté graphiquement.

12. Appareil à signal de mesure (100) selon l'une des revendications précédentes, le processeur (105) étant configuré pour mettre à disposition le code (109) pouvant être représenté graphiquement de manière transmissible électriquement, notamment sans fil vers un lecteur (200) .

13. Appareil à signal de mesure (100) selon l'une des revendications précédentes, lequel possède en outre un capteur destiné à l'acquisition de la grandeur physique, le capteur étant relié électriquement au port de capteur (101) destiné à la mise à disposition de la grandeur physique, et/ou lequel possède en outre une interface de communication servant à la réception de la grandeur physique, l'interface de communication étant reliée électriquement au port de capteur destiné à la mise à disposition de la grandeur physique.

14. Système, comprenant :
un appareil à signal de mesure (100) selon l'une des revendications précédentes ; et
un lecteur (200) destiné à lire un code (109) pouvant être représenté graphiquement au moyen d'un dispositif d'affichage (111), lequel possède une indication à propos d'une valeur mesurée (103) d'une grandeur physique, ainsi qu'une instruction de manipulation (107) destinée à la manipulation électronique de la valeur mesurée (103), le lecteur (200) comportant ce qui suit :
un dispositif d'acquisition optique, notamment une caméra d'imagerie, qui est configuré pour acquérir optiquement le code (109) pouvant être représenté graphiquement ;
un processeur, qui est configuré pour décoder le code (109) pouvant être représenté graphiquement afin d'obtenir la valeur mesurée (103) ainsi que l'instruction de manipulation (107) ;
le lecteur (200) étant configuré pour manipuler la valeur mesurée (103) conformément à l'instruction de manipulation (107), l'appareil à signal de mesure (100) étant configuré pour acquérir périodiquement la grandeur physique et le dispositif d'affichage (111) étant configuré pour actualiser la représentation du code pouvant être représenté graphiquement à chaque acquisition de la grandeur physique.
